# EUROPEAN PATENT SPECIFICATION

(11) **EP 2 933 353 B1**
(45) Date of publication and mention of the grant of the patent: **20.12.2017**
(21) Application number: 14305572.1
(22) Date of filing: 17.04.2014
(51) Int. Cl.: C23C 16/04, C23C 16/32

(54) **Method for producing fiber-reinforced composites**
Verfahren zur Herstellung von faserverstärkten Verbundstoffen
Procédé pour produire des matériaux composites renforcés par des fibres

(43) Date of publication of application: 21.10.2015
(73) Proprietor: Safran Ceramics, 33185 Le Haillan (FR)
(72) Inventor: Dussarrat, Christian, Adachi Tokyo 120-0223 (JP)
(74) Representative: Cabinet Beau de Loménie

(56) References cited:
- US-A- 5 733 655
- JINGYI DENG ET AL: "CARBON-FIBER-REINFORCED COMPOSITES WITH GRADED CARBON-SILICON CARBIDE MATRIX COMPOSITION", JOURNAL OF THE AMERICAN CERAMIC SOCIETY, BLACKWELL PUBLISHING, MALDEN, MA, US, vol. 82, no. 6, 1 June 1999 (1999-06-01), pages 1629-1632, XP000831136, ISSN: 0002-7820
- BAKLANOVA N I ET AL: "Protective ceramic multilayer coatings for carbon fibers", SURFACE AND COATINGS TECHNOLOGY, ELSEVIER, AMSTERDAM, NL, vol. 201, no. 6, 12 June 2006 (2006-06-12) , pages 2313-2319, XP024996231, ISSN: 0257-8972, DOI: 10.1016/J.SURFCOAT.2006.03.046 [retrieved on 2006-12-04]

## Description

The invention concerns a method of producing fiber-reinforced composites and the use of said composites in several industries.

Fiber-reinforced composites are gaining momentum in aeronautics applications to use lighter, cheaper, oxidation, corrosion resistant and more cost-effective materials to proceed, instead of the metal alloys used still nowadays that assure the mechanical cohesion of the materials.

Fiber-reinforced composites can be used in nuclear industry in radiation environment, in burners for corrosion and oxidation resistant applications, in distillation systems as anticorrosive material. It can be attractive to use this type of materials for new generation batteries to increase their capacitances, e.g. lithium incorporation, while maintaining good electrical properties.

The current invention is related to the manufacturing of silicon carbide matrix or shells by chemical vapor deposition (CVD) and chemical vapor infiltration (CVI) processes. CVD comprises the deposition of solid phases on substrates and the decomposition of volatile or gaseous compounds which contain the solid phase elements while the term of chemical vapor infiltration is commonly used if this deposition takes place around porous substrates, or in the cavities of a porous structure, forming a perform, so as to form a matrix with good interface properties between the matrix and the substrate.

Chemical vapor deposition (CVD) and/or chemical vapor infiltration (CVI) are of significance primarily with respect to the deposition and infiltration of refractory materials such as silicon carbides, silicon carbonitrides or silicon borocarbides. CVI methods allow a densification of structure or, when the porous structure consists of fibers, an introduction of a matrix and, with this, the production of composite, strengthened fiber materials.

The chemical vapor infiltration (CVI) technology is one of the most attractive industrially available methods to produce fiber-reinforced ceramic matrix composites (CMCs). CVI is a process where a porous preform is placed in a surrounding of a reactive gas mixture, which, if thermally activated, decomposes and yields a solid deposit that fills the pores inside the preform.

The main advantages of this technique are the possibility to manufacture complex net or near-net-shape components at relatively low temperatures, avoiding potential damages of the textile structures, typically used as preform, and to control and modify the microstructure of the matrix.

This technique allows the production of strong and tough composites and is ideal to produce composites with characteristics of resistance to corrosion, erosion, and wear. These important features generally overcome the main drawbacks of the CVI process, such as the long manufacturing time of typically some days up to weeks and the run-to-run reproducibility that in some case still limits the applicability of this technology.

In particular, the CMCs that take more advantages from the CVI technology are silicon carbide (SiC) ceramic reinforced with SiC-fibers (SiC f/SiC composites), carbon (C) ceramic reinforced with C-fibers (Cf/C composites). and silicon carbide (SiC) ceramic reinforced with C-fibers (Cf/SiC composites). Cf/SiC and SiCf/SiC composites produced by CVI present excellent high-temperature properties including high strength, modulus of elasticity, creep and corrosion resistance, resistance to shocks, fatigue and damage, chemical stability, and a greater fracture toughness compared to unreinforced SiC. Also, the fabrication of C_{f}/C composites by CVI technology offers considerable advantages, like the control over the microstructure of carbon matrix (CVI - derived carbon or pyrocarbon [PyC]), which presents excellent physical and thermal properties and can be obtained under certain infiltration conditions. CVI is widely used to fabricate C_{f}/C composites when high performance of the final material is needed, for example, for applications as aircraft disk brakes.

The good mechanical properties at room and high temperatures exhibited by CVI - processed composites largely depend on the fiber-matrix interphase. Fiber-matrix interphases in CVI composites consist of a thin coating layer (less than 1 µm thick) of one or more materials deposited on the fiber during the same CVI process.

The CVI technique is based on the principle of impregnating a porous body, consisting of an array of fibers (preform), by means a mixture of precursor gases that reacts, decomposes, and precipitates the solid within the pore network of a heated substrate. The chemical reaction takes place between the gaseous species that flow by diffusion within the pores.

The conditions for the application of the CVI technology to a given porous substrate are interconnection of the pores and thermal and chemical stability of the substrate under the CVI conditions. Porous preforms generally present a complex pore size distribution that depends on the architecture of the preform.

The principal scope of CVI is to increase the density of the porous preform by a percentage range from 100% to 900% (i.e., by a factor of 2 - 10), depending on the properties required by the final application.

In CVI, the different constituents of the composite, that is, the interphase, the matrix, and an external coating, are sequentially deposited from precursor gases at high temperatures (900°C - 1200°C) and under reduced pressures (or sometimes at atmospheric pressure) typically.

On top of their lightness, the main interest of fiber-reinforced ceramics is due to their nonbrittle mechanical behavior and improved reliability with respect to monolithic ceramic. This nonbrittle performance is strictly influenced by the processing, and in particular, it is observed only for well - processed materials. The CVI technique, if correctly applied, perfectly fulfills the processing requirements, resulting in CMCs with advanced mechanical and temperature properties.

Thus, it is important to take care in:
(i) avoiding fiber damage during composite processing,
(ii) protecting both the fibers and their interphases by coatings against environmental effects (e.g. oxidation).

During a tensile test, fibrous CMCs follow, under such conditions, a nonlinear stress-strain behavior. In addition, they exhibit both high crack propagation resistance and high failure energy due to different damaging mechanisms such as matrix microcracking, fiber-matrix debonding and friction, and especially, fiber pullout, which is a highly energy-absorbing mechanism.

The applications of CVI processing materials cover a wide range of CMCs such as carbon-carbon, carbon-silicon carbide, and silicon carbide-silicon carbide composites. Due to their attractive properties like great resistance to high temperature and corrosive environments, damage tolerance, and toughness, they find applications in brakes, heat exchangers, gas turbines, structural components in aerospace industry, in nuclear reactors, and in heat engines.

Silicon carbide materials are useful because of its very good mechanical, physical, and chemical properties including corrosion resistance, chemical stability, and temperature stability.

The advantageous properties of CVI C_{f}/SiC composites are related to excellent mechanical strength, low density, high toughness, creep, fatigue and corrosion resistance, and high damage tolerance in case of impacts and thermal shocks, thus ensuring outstanding reliability even at very high temperatures. The properties of CVI C_{f} /SiC composites are very different from those of monolithic ceramics and glasses, and from other types of composites, allowing the replacement of metals and ceramics in many technical applications, in which resistance to loads, high temperatures, and aggressive environments are strongly required.

Frequent applications of SiC-based composites are reusable thermal protections, gas turbines, and, in general, structural parts used at high temperatures and under oxidizing atmospheres.

Both chemical vapor deposition and chemical vapor infiltration are complex processes. In the chemical vapor deposition of compounds such as silicon carbide, it is difficult to attain solid phase deposition in stoichiometric compositions for larger parts in the generation of a coat of homogeneous thickness. In gas phase infiltration, the volatile or gaseous starting compounds must be transported into the depth of the pores before adsorbing. Decomposition occurring on the surface of the porous structure in the pore entrances should be prevented or at least avoided, as it would result in pores getting clogged and not filled, hence resulting in a significant remaining porosity.

Different methods for chemical vapor infiltration (CVI) are reported in the literature. The basic method consists in maintaining the process at constant temperature and pressure, typically only low pressures or partial pressures of precursors can be used, when necessary with addition of inert or dilution gases, so that very long infiltration times are needed.

Infiltration times can be reduced in chemical vapor infiltration regime through the use of methyltrichlorosilane (MTS) as silicon carbide precursor, the precursor being preheated to temperatures well above the decomposition temperature of MTS i.e. above about 900°C, while at the same time setting pressures up to about 13.3 kPa.

Preheating MTS to such temperatures leads to a rather high growth rate of silicon carbide materials. This achieves a high production speed but at the same time leads to uneven deposits, particularly on the surface, and to low pore filling. Thus optimal or maximal pore filling is more effective at very slow deposition or infiltration rates.

Accordingly, low pressures, and particularly low partial pressures, are recommended in order to successfully realize gas phase infiltration. The pressures under the conditions of chemical vapor infiltration in the industry are at least one to two orders of magnitude below normal pressure.

Precursors may be partially mixed with inert gases so that their partial pressure, and the deposition rate, can be further lowered. Due to the low partial pressures, the process needs long infiltration times of up to several weeks.

Another technology consists in using a temperature gradient, as taught in US 5,411,763 (Weaver et al.) and US 5,348,774 (Golecki et al.). In this method, heat is removed from the side of the porous substrate facing the process gas stream by suitable measures, for example by cooling by the stream.

JINGYI DENG ET AL: "CARBON-FIBER-REINFORCED COMPOSITES WITH GRADED CARBON-SILICON CARBIDE MATRIX COMPOSITION",JOURNAL OF THE AMERICAN CERAMIC SOCIETY, BLACKWELL PUBLISHING, MALDEN, MA, US, vol. 82, no. 6, 1 June 1999 (1999-06-01), pages 1629-1632, XP000831136, ISSN: 0002-7820 discloses a method of producing fiber-reinforced composites comprising producing a silicon carbide matrix by impregnating an array of fibers by methyltrichlorosilane and C2H2 at 1000-1300°C and less than 5 kPa. Use of the resulting products in aerospace applications is further disclosed. The side of the porous substrate opposite to the gas stream is adjacent to a heating element. It is in this way that a temperature gradient crucial to the method is established normal to the surface of the substrate.

The surface temperature on the cold side is adjusted with the gas stream such that very little or no deposition takes place. It is in this way that narrowing of the pores in this region is avoided.

The disadvantage of this method is the very high gas throughput necessary for cooling. The low yield of deposited material entails long production times. Complex equipment is needed for the heating.

In order to prepare those materials, the materials are engineered to optimize synergies between the fibers and the matrix. The mechanical properties are enhanced by the usage of appropriate combination of materials of the matrix and the fibers, including the formation of interface phases between the matrix and the fibers.

Popular fibers are made of carbons (C) or silicon carbide (SiC), possibly porous, and one of the most interesting material for matrix is silicon carbide.

The matrix is formed by Chemical Vapour Infiltration (CVI) around fibrous preforms, the process allowing the formation of good interfacing between the matrix and the fibers, as long as sufficient time is provided to allow the SiC precursor to infiltrate around the matrix.

The growth rate of silicon carbide on ceramics with sufficient adhesion is estimated to 1-3 µm/hr.

A too fast process results in limited adhesion of the matrix and the fibers and inducing a significant porosity of the silicon carbide matrix, hence impacting severely the mechanical properties.

Also as matrix grows around the fibers during the CVI process, the junctions between the silicon carbide grown around the fibers should avoid the formation of residual pores and should be of superior quality to assure mechanical properties.

The formation of pores due to an inadequate CVI process is very detrimental to the mechanical properties of the ceramics. In summary, the current process needs to find a compromise between an excellent adhesion between matrix and fibers and a fast enough ceramic formation process.

The standard precursor is methyltrichlorosilane, in combination with hydrogen, at about 950°C-1200°C, at operating pressures of 1 kPa to 40 kPa.

Other precursors like methyldichlorosilane, trimethylsilane or tetramethylsilane were tried but did not allow better or even equivalent process conditions and/or ceramic performances.

Aeronautics industry is therefore looking for faster growth rates, with excellent matrix/fibers adhesion and without residual pores to assure superior mechanical properties.

One task which provided the basis for this invention is to create a CVI method by which a high level of pore filling during a pre-set production time can be achieved, or alternatively, a shorter production time achieved for pre-set pore filling levels.

The invention concerns a method of producing fiber-reinforced composites according to claim 1. In chemistry, pi bonds (π bonds) are covalent chemical bonds where two lobes of one involved atomic orbital overlap two lobes of the other involved atomic orbital.

The Greek letter π in their name refers to p orbitals, since the orbital symmetry of the pi bond is the same as that of the p orbital when seen down the bond axis. p orbitals often engage in this sort of bonding. d orbitals also engage in pi bonding, and form part of the basis for metal-metal multiple bonding.

Pi bonds are usually weaker than sigma bonds; the C-C double bond has a bond energy less than twice the C-C single bond bond energy; which leads to the conclusion that the p orbitals overlap to form a weaker bond than when s orbitals overlap to form a sigma bond.

From the perspective of quantum mechanics, this bond's weakness is explained by significantly less overlap between the component p-orbitals due to their parallel orientation. This is contrasted by sigma bonds which form bonding orbitals directly between the nucleus of the bonding atoms, resulting in greater overlap and a strong sigma bond.

Pi bonds result from overlap of atomic orbitals that are in contact through two areas of overlap. Pi-bonds are more diffuse bonds than the sigma bonds. Electrons in pi bonds are sometimes referred to as pi electrons. Molecular fragments joined by a pi bond cannot rotate about that bond without breaking the pi bond, because rotation involves destroying the parallel orientation of the constituent p orbitals.

For homonuclear diatomic molecules, bonding π molecular orbitals have only the one nodal plane passing through the bonded atoms, and no nodal planes between the bonded atoms.

According to other embodiments, the present disclosure concerns:
A method as defined above, wherein the chemical vapor infiltration process comprises a step of flowing at least one silicon precursor and at least one carbon precursor together with hydrogen over a substrate heated from 700°C to 1400°C and preferably from 900°C to 1100°C.

A method as defined above, wherein the chemical vapor infiltration process comprises a step of flowing at least one silicon precursor and at least one carbon precursor together with hydrogen over a substrate at a pressure from 10 Pa to 150 kPa and preferably from 1 kPa to 20 kPa.

A method as defined above, wherein the silicon carbide precursor is selected in the list: tetrachlorosilane; trichlorosilane; dichlorosilane ; monochlorosilane ; silane; vinyltrichlorosilane; allyltrichlorosilane; vinyldichlorosilane; allyldichlorosilane; divinyldichlorosilane, diallyldichlorosilane ; Vinylmonochlorosilane; Allylmonochlorosilane; divinylmonochlorosilane, trivinylmonochlorosilane ; diallylmonochlorosilane, triallylmonochlorosilane, monomethylsilane ; dimethylsilane ; monovinylsilane; divinylsilane ; trivinylsilane ; tetravinylsilane ; monoallylsilane; diallylsilane; triallylsilane, tetraallylsilane.

A method as defined above wherein the carbon precursor is selected in the list: acetylene, ethylene, propylene, butene.A method as defined above,, wherein the residual porosity of the silicon carbide matrix is less than 4% and preferably comprised between 0.5% to 3%.

The use of at least one fiber-reinforced composite produced by a method as defined above for manufacturing heat exchangers, gas turbines or structural components in aerospace industry.

The use of at least one fiber-reinforced composite produced by a method as defined above for manufacturing heat exchangers, gas turbines or structural components of nuclear reactors.

The use of at least one fiber-reinforced composite produced by a method as defined above for manufacturing structural components of batteries.

The concept to have the highest infiltration in the fibers and to avoid the formation of residual pores is to use precursors with low sticking coefficient.

By using carbon precursors containing π-bonds, in combination with a silicon source, more aggressive growth conditions can be used, thus allowing higher growth rates of the matrix and fibrous performs, while sustaining excellent mechanical properties and corrosion resistance.

The composite prepared by this method has enhanced mechanical properties, corrosion resistance and thermal shock resistance. Residual stresses can be lowered through the use of lower infiltration temperatures, and large and/or complex shapes can be produced. Very pure and uniform matrix can be obtained by carefully controlling the flow rates and purity of the different gases. The residual porosity is reduced from 15% to less than 3%.

### CVI Reactors:

CVI systems to form a dense layer of silicon carbide is comprised of the following:
1) a gas delivery system for each precursor to the reactor chamber,
2) a reactor chamber within which deposition takes place,
3) a substrate loading and unloading mechanism for insertion and removal of deposition substrates,
4) a heating device to provide the temperatures required for reaction of the precursors,
5) a vacuum system for the renewal or removal of all gases involved in the reaction.

Those equipment sets are typically followed by an exhaust system for the abatement of volatile by-products from the reaction chamber so as to prevent the release of any harmful compounds into the atmosphere.

CVI allows the growth of a dense layer of silicon carbide materials into and around the porous pre-forms through flowing hydrogen, silicon and/or carbon sources over a substrate heated from about 800°C to about 1400°C.

In this temperature range, the silicon source(s) will react to grow a silicon carbide material around the pre-forms.

By using appropriate silicon source(s), silicon carbide will be uniformly deposited on complex surfaces. The pre-forms will be thus densified by chemical vapor infiltration (CVI) of the silicon carbide material.

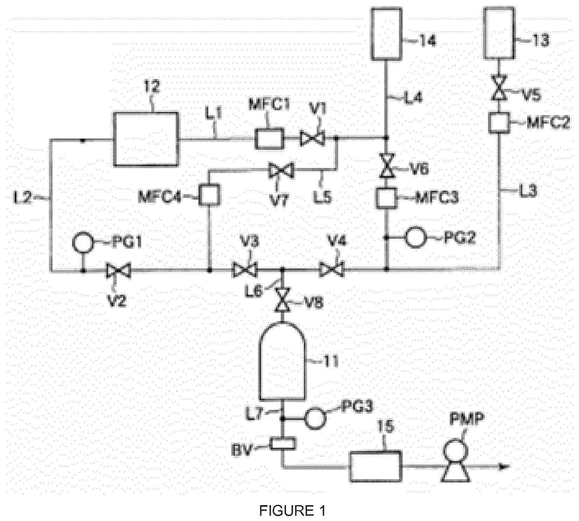

The figure 1 represents a block diagram that schematically illustrates an example of a CVI-based apparatus that can be used to execute the inventive method for fiber-reinforced composites.

The apparatus illustrated in figure 1 is provided with a reaction chamber **11,** a feed source **12** for a volatile silicon carbide precursor, a feed source **13** for reducing agent gas (typically hydrogen), and a feed source **14** for an inert gas that can be used as a carrier gas and/or dilution gas.

A substrate loading and unloading mechanism allows the insertion and removal of deposition substrates in the reaction chamber **11.**

A heating device is provided to reach the reaction temperatures required for reaction of the precursors.

The volatile silicon carbide precursor feed source **12** may use a bubbler method as described above to introduce a volatile silicon carbide precursor into the reaction chamber **11,** and is connected to the inert gas feed source **14** by the line L**1**. The line L**1** is provided with a shutoff valve V**1** and a flow rate controller, for example, a mass flow controller MFC**1**, downstream from this valve.

The volatile silicon carbide precursor is introduced from its feed source **12** through the line L**2** into the reaction chamber **11.** The following are provided considered from the upstream side: an ultraviolet spectrometer UVS, a pressure gauge PG**1**, a shutoff valve V**2**, and a shutoff valve V**3**.

The reducing agent gas feed source **13** comprises a vessel that holds the reducing agent in gaseous form. The reducing agent gas is introduced from its feed source **13** through the line L**3** into the reaction chamber **11.** A shutoff valve V**4** is provided in the line L**3**. This line L**3** is connected to the line L**2**.

The inert gas feed source **14** comprises a vessel that holds inert gas in gaseous form. The inert gas can be introduced from its feed source through the line L**4** into the reaction chamber **11.**

Line L**4** is provided with the following considered from the upstream side: a shutoff valve V**6**, a mass flow controller MFC**3**, and a pressure gauge PG**2**. The line L**4** joins with the line L**3** upstream from the shutoff valve V**4**.

The line L**5** branches off upstream from the shutoff valve V**1** in the line L**1**; this line L**5** joins the line L**2** between the shutoff valve V**2** and the shutoff valve V**3**. The line L**5** is provided with a shutoff valve V**7** and a mass flow controller MFC**4** considered from the upstream side.

The line L**6** branches off between the shutoff valves V**3** and V**4** into the reaction chamber **11.** This line L**6** is provided with a shutoff valve V**8**.

A line L**7** that reaches to the pump PMP is provided at the bottom of the reaction chamber **11.** This line L**7** contains the following considered from the upstream side: a pressure gauge PG**3**, a butterfly valve BV for controlling the backpressure, and a cold trap **15.** This cold trap **15** comprises a tube that is provided with a cooler over its circumference and is aimed at collecting the silicon carbide precursor and the related by-products.

The production of fiber-reinforced composites using the apparatus illustrated in FIG. 1 commences with the closing of shutoff valves V**1**, V**2**, and V**5** and the opening of shutoff valves V**6**, V**7**, V**3**, V**4**, and V**8** and the introduction of inert gas by the action of the pump PMP from the inert gas feed source **14** through the line L**4** into the line L**6** and into the reaction chamber **11.**

The shutoff valve V**5** is then opened and reducing agent gas is introduced into the reaction chamber **11** from the reducing agent gas feed source **13.** The shutoff valves V**1** and V**2** are opened and inert gas is introduced from the inert gas feed source **14** through the line L**1** and into the volatile silicon carbide precursor feed source **12.**

This results in the introduction of gaseous silicon carbide precursor through the line L**2** and the line L**6** into the reaction chamber **11.** The reducing agent gas and volatile silicon carbide compound react in the reaction chamber **11,** resulting in the formation of a silicon carbide coating on the fibers, the coating will coalesce to form a silicon carbide matrix and finally the formation of fiber-reinforced composites.

### EXAMPLES

### Comparative example 1:

Using the set-up described in "CVI reactors" section, the standard silicon carbide precursor, methyltrichlorosilane, was flown at a rate of 5 sccm. Argon is flown at 1980 sccm as a carrier gas and a dilution gas, and hydrogen, a reductant, is flown at 20 sccm. The reactor is heated at 950°C, with a total pressure set at 1 kPa. At different durations of experiment (3, 5, 10 minutes), the growth rate was consistently measured at 0.78 µm/hour.

### Comparative example2:

Using the set-up described in "CVI reactors" section, the standard silicon carbide precursor, methyltrichlorosilane (MTS), was flown at a rate of 10 sccm. Argon is flown at 1980 sccm as a carrier gas and a dilution gas, and hydrogen, a reductant, is flown at 20 sccm. The reactor is heated at 950°C, with a total pressure set at 1 kPa. For a duration of 3 minutes, the growth rate was 1.3 µm/hour.

### Example 1:

Using the set-up described in "CVI reactors" section, a silicon precursor, vinyltrichlorosilane combined to carbon source, acetylene, was flown at a rate of 5 sccm.

Argon is flown at 1980 sccm as a carrier gas and a dilution gas, and hydrogen, a reductant, is flown at 20 sccm. The reactor is heated at 950°C, with a total pressure set at 1 kPa. For a duration of 3 minutes, the growth 1.3 µm/hour, almost doubling the growth rate compared to MTS in the same experimental conditions.

## Claims

1. A method of producing fiber-reinforced composites comprising:
- producing a silicon carbide matrix by impregnating an array of fibers by at least one silicon precursor and at least one carbon precursor together with hydrogen, through a chemical vapour infiltration process, wherein said carbon precursor contains at least one π-bond, and **characterized in that** said silicon precursor is vinyltrichlorosilane.

2. Method according to Claim 1 wherein the chemical vapor infiltration process comprises a step of flowing at least one silicon precursor and at least one carbon precursor together with hydrogen over a substrate heated from 700°C to 1400°C and preferably from 900°C to 1100°C.

3. Method according to Claim 1 or Claim 2 wherein the chemical vapor infiltration process comprises a step of flowing at least one silicon precursor and at least one carbon precursor together with hydrogen over a substrate at a pressure from 10 Pa to 150 kPa and preferably from 1 kPa to 20 kPa.

4. Method according to one of claims 1 to 3, wherein the carbon precursor is selected in the list: acetylene, ethylene, propylene, butene.

5. Method according to one of claims 1 to 4, wherein the residual porosity of the silicon carbide matrix is less than 4% and preferably comprised between 0.5% to 3%.

## Patentansprüche

1. Verfahren zum Herstellen faserverstärkter Verbundwerkstoffe, umfassend:
Herstellen einer Siliciumcarbidmatrix durch Imprägnieren eines Faserarrays mit wenigstens einem Siliciumvorläufer und wenigstens einem Kohlenstoffvorläufer zusammen mit Wasserstoff durch ein chemisches Dampfinfiltrationsverfahren, wobei der Kohlenstoffvorläufer wenigstens eine π-Bindung enthält, und **dadurch gekennzeichnet, dass** der Siliciumvorläufer Vinyltrichlorsilan ist.

2. Verfahren nach Anspruch 1, wobei das chemische Dampfinfiltrationsverfahren einen Schritt umfasst, in dem wenigstens ein Siliciumvorläufer und wenigstens ein Kohlenstoffvorläufer zusammen mit Wasserstoff über ein Substrat fließt, das auf 700° C bis 1.400° C, vorzugsweise auf 900° C bis 1.100° C erhitzt ist.

3. Verfahren nach Anspruch 1 oder 2, wobei das chemische Dampfinfiltrationsverfahren einen Schritt umfasst, in dem wenigstens ein Siliciumvorläufer und wenigstens ein Kohlenstoffvorläufer zusammen mit Wasserstoff über ein Substrat bei einem Druck von 10 Pa bis 150 kPa, vorzugsweise von 1 kPa bis 20 kPa fließt.

4. Verfahren nach einem der Ansprüche 1 bis 3, wobei der Kohlenstoffvorläufer aus der Liste ausgewählt ist: Acetylen, Ethylen, Propylen und Buten.

5. Verfahren nach einem der Ansprüche 1 bis 4, wobei die verbleibende Porosität der Siliciumcarbidmatrix weniger als 4 % beträgt und vorzugsweise zwischen 0,5 % bis 3 % umfasst ist.

## Revendications

1. Procédé pour produire des composites renforcés par des fibres comprenant :
- la production d'une matrice de carbure de silicium par imprégnation d'un réseau de fibres avec au moins un précurseur de silicium et un précurseur de carbone conjointement avec de l'hydrogène, par l'intermédiaire d'un traitement d'infiltration de vapeur chimique, dans lequel ledit précurseur de carbone contient au moins une liaison ·, et **caractérisé en ce que** ledit précurseur de silicium est le vinyltrichlorosilane.

2. Procédé selon la revendication 1, dans lequel le traitement d'infiltration de vapeur chimique comprend une étape d'écoulement d'au moins un précurseur de silicium et d'au moins un précurseur de carbone conjointement avec de l'hydrogène sur un substrat chauffé à une température de 700 °C à 1 400 °C et de préférence de 900 °C à 1 100°C.

3. Procédé selon la revendication 1 ou la revendication 2, dans lequel le traitement d'infiltration de vapeur chimique comprend une étape d'écoulement d'au moins un précurseur de silicium et d'au moins un précurseur de carbone conjointement avec de l'hydrogène sur un substrat sous une pression de 10 Pa à 150 kPa et de préférence de 1 kPa à 20 kPa.

4. Procédé selon l'une quelconque des revendications 1 à 3, dans lequel le précurseur de carbone est choisi dans la liste suivante : acétylène, éthylène, propylène, butène.

5. Procédé selon l'une quelconque des revendications 1 à 4, dans lequel la porosité résiduelle de la matrice de carbure de silicium est inférieure à 4 % et est de préférence comprise entre 0,5 % et 3 %.
